# EUROPÄISCHE PATENTANMELDUNG

(11) **EP 1 432 300 A2**
(43) Veröffentlichungstag der Anmeldung: **23.06.2004**
(21) Anmeldenummer: 03104418.3
(22) Anmeldetag: 27.11.2003
(51) Int. Cl.: H05K 13/04

(54) **Verfahren und Vorrichtung zum Aufbringen einer Klebstoffschicht auf flächige Bauelemente und Bestückvorrichtung zum Bestücken von flächigen Bauelementen**

(30) Priorität: 16.12.2002 DE 10258800
(71) Anmelder: SIEMENS AKTIENGESELLSCHAFT, 80333 München (DE)
(72) Erfinder: Schiebel, Günter, 81379, München (DE)

(57) **Zusammenfassung**

Die Erfindung schafft ein Verfahren und eine Vorrichtung zum Aufbringen einer Klebstoffschicht auf flächige Bauelemente (100), insbesondere auf Bare Dies, Flip Chips und/oder Ball Grid Arrays, bei dem eine Unterseite eines von einer Haltevorrichtung (110) gehaltenen Bauelements (100) in eine Klebstoffschicht (130) eingetaucht wird. Durch die Verwendung einer Hebeeinrichtung wird sichergestellt, dass das Bauelement (100) bei einem Anheben der Haltevorrichtung (110) nicht von dieser gelöst wird, weil die Klebekraft des Klebstoffs (130) größer als die Haltekraft der Haltevorrichtung (110) ist. Dabei wird das Bauelement (100) aus der Klebstoffschicht (130) herausgedrückt, wobei die Hebeeinrichtung lediglich partiell an der Unterseite des Bauelements (100) angreift. Die Erfindung schafft ferner eine Bestückvorrichtung zum schnellen Bestücken von flächigen Bauelementen (300), bei der die Bauelemente (300) zunächst von einer Vorrichtung (380) zum Aufbringen einer Klebstoffschicht mit Klebstoff (330) benetzt und nachfolgend auf einem Bauelementeträger (360) oder auf ein bereits bestücktes Bauelement aufgesetzt werden.

## Beschreibung

Die Erfindung betrifft ein Verfahren sowie eine Vorrichtung zum Aufbringen einer Klebstoffschicht auf flächige Bauelemente, insbesondere auf Bare Dies, Flip Chips und/oder Ball Grid Arrays. Die Erfindung betrifft ferner eine Bestückvorrichtung zum Bestücken derartiger Bauelemente auf einem Bauelementeträger.

Die Miniaturisierung von elektronischen Baugruppen, d.h. der Aufbau von elektronischen Schaltungen auf möglichst geringem Raum, beruht unter anderem darauf, dass hochintegrierte elektronische Bauelemente mit einer Vielzahl von elektrischen Anschlüssen verwendet werden, welche nicht nur seitlich des Bauelements angeordnet sondern über eine flächige Unterseite des Bauelements verteilt sind. Dies ermöglicht auf geringem Raum eine Vielzahl von elektrischen Kontaktierungen zwischen einem Bauelement und einem Bauelementeträger. Bauelementeträger sind beispielsweise Leiterplatten oder Substrate.

Im folgenden werden unter dem Begriff Bauelemente alle bestückfähigen Elemente verstanden, insbesondere elektronische Bauelemente, elektromechanische Bauelemente, Stecker und Steckverbindungen für elektrische und mechanische Kontakte sowie Abschirmbleche. Der Begriff elektronische Bauelemente umfasst selbst eine Vielzahl von verschiedenen Bauelementen, beispielsweise optoelektronische Bauelemente, SMD-Bauelemente (Surface Mount Device-Bauelemente) und hochintegrierte flächige Bauelemente. Dazu zählen beispielsweise Bare Dies, Flip Chips, Ball Grid Arrays und RFID-Bauelemente, welche für sog. Transponder verwendet werden.

Ein Problem bei der Bestückung von Bauelementen besteht darin, dass das bestückte Bauelement gegenüber dem Bauelementeträger ein bestimmtes Klebevermögen aufweisen muss, damit es auf dem Bauelementeträger nicht verrutscht und bei einem nachfolgenden Lötvorgang exakt in der vorgegebenen Bestückposition verlötet wird. Nur dann ist ein sicherer elektrischer Kontakt zwischen den Anschlüssen des Bauelements und den auf dem Bauelementeträger vorgesehenen Anschlussflächen gewährleistet.

Zur räumlichen Fixierung von bestückten Bauelementen auf einem Bauelementeträger werden deshalb klebrige Substanzen eingesetzt, die eine stabile räumliche Lage zumindest bis zu dem Lötvorgang gewährleisten, welcher dann dauerhaft eine feste Verbindung zwischen Bauelement und Bauelementeträger gewährleistet.

Ein derartiges temporäres Fixieren der Bauelemente auf dem Bauelementeträger ist unter anderem bei sog. Flip Chips und/oder Ball Grid Arrays erforderlich. Das Material mit Klebevermögen besteht häufig aus Lotpaste und eventuell aus einem Flussmittel.

An dieser Stelle wird darauf hingewiesen, dass der Begriff Ball Grid Array neben herkömmlichen Ball Grid Arrays auch sog. Chip Scale Packages bzw. Micro Ball Grid Arrays umfasst.

Eine andere Art von Klebstoff wird üblicherweise bei sog. Bare Dies verwendet. Bare Dies sind nackte Bauelemente, die sich in keinem Gehäuse befinden und im Rahmen der Technologie Chip on Board auf einem Bauelementeträger aufgeklebt und mittels sog. Wire Bonding Technik mit dem Bauelementeträger kontaktiert werden. Bei dieser Technik werden auf der Oberseite der Bare Dies ausgebildete Anschlüsse mittels eines feinen Drahtes mit auf dem Bauelement vorgesehenen Anschlussflächen kontaktiert. Diese Art der Nacktchip-Bestückung wird allge mein als Die-Bonding bezeichnet. Zum Bestücken von Bare Dies auf Bauelementeträgern ist demzufolge ein Klebstoff erforderlich, welcher eine dauerhafte Verklebung des Bare Dies mit dem Bauelementeträger bewirkt.

Aus der WO 1999/18766 ist ein Verfahren zum Bestücken von Halbleiterbauelementen auf Schaltungsträgern bekannt, bei dem ein Klebstoff in Form von einzelnen Tropfen auf einem Schaltungsträger aufgebracht wird und somit das Bauelement an einer oder an mehreren Stellen mit dem Schaltungsträger verklebt wird. Zur Erzeugung einer flächigen Klebstoffschicht wird der Schaltungsträger derart in Rotation versetzt, dass der Klebstofftropfen infolge der Zentrifugalkraft radial nach außen zerfließt. Dieses Verfahren hat jedoch den Nachteil, dass zur Erzeugung einer flächigen Klebstoffschicht der Schaltungsträger einer aufwendigen und langwierigen Behandlung unterzogen werden muss, so dass die Herstellungskosten entsprechend hoch sind.

Gemäß einem bekannten Verfahren wird der Klebstoff auf dem Chip-Einbauplatz auf dem Bauelementeträger mittels sog. Dispenserköpfen aufgetragen. Dieses Verfahren ist jedoch insbesondere für größere Flächen sehr zeitaufwendig, da entweder mehrere Klebstoffpunkte gesetzt werden müssen oder der erforderliche Klebstoff kontinuierlich, bevorzugt mäanderförmig oder in Form einer eckigen Spirale, aufgebracht wird.

Im Zusammenhang mit der Bestückung von Flip Chips bzw. Ball Grid Arrays ist ferner bekannt, dass die Bauelemente kurzzeitig auf einen klebrigen Film aus Flussmittel oder Klebstoff abgesenkt werden. Die Schichtdicke der Klebstoffschicht ist dabei derart gewählt, dass nur die Anschlusskugeln und auf keinen Fall die gesamte Bauelementunterseite mit dem Klebstoff benetzt wird. Dies wird dadurch erreicht, dass die für die Schichtdicke der Klebstoffschicht eine Dicke gewählt wird, die ungefähr so groß ist wie der halbe Durchmesser der Anschlusskugeln. In diesem Fall ist das Herausheben der Bau elemente aus dem klebrigen Film unproblematisch, da nur die Anschlusskugeln und somit lediglich ein sehr kleiner Teil der flächigen Bauelementunterseite mit dem Klebstoff benetzt ist. Eine flächige Benetzung der Unterseite eines Bauelements mit Klebstoff führt jedoch im allgemeinen dazu, dass das Bauelement nicht von der Klebstoffschicht entfernt werden kann, da die im allgemeinen mittels Vakuum erzeugte Haltekraft einer Haltevorrichtung für das Bauelement nicht ausreicht, um die Klebekraft der Klebstoffschicht auf das Bauelement zu überwinden.

Das o.g. Verfahren, bei dem die Bauelemente kurzzeitig auf einen klebrigen Film aus Klebstoff und/oder Flussmittel abgesenkt werden, eignet sich jedoch nicht für sog. Wafer Level Underfilled Packages. Dies sind Bauelemente wie beispielsweise Flip Chips und/oder Ball Grid Arrays, die an ihrer flächigen Unterseite mit einer vorgehärteten Schicht versehen sind, die Klebstoff und Flussmittel aufweist. Diese Schicht dient dazu, dass die Bauelemente bei einem Lötvorgang in einem Ofen durch ein temporäres Aufschmelzen der Klebstoffs fest mit dem Bauelementeträger verklebt werden, so dass mechanische Spannungen, die insbesondere auf unterschiedlichen thermischen Ausdehnungskoeffizienten von Bauelement und Bauelementeträger beruhen, aufgefangen werden. Da bei Wafer Level Underfilled Packages die Anschlusskugeln kaum aus der Underfill-Klebstoffschicht herausragen, wird bei einem kurzzeitigen Absenken eines derartigen Bauelements auf einen klebrigen Film stets die ganze Bauelement-Unterseite mit Klebstoff benetzt, so dass die Haltekraft der Haltevorrichtung i.a. nicht ausreicht, um das flächig benetzte Bauelement von der Klebstoffschicht zu entfernen.

Der Erfindung liegt die Aufgabe zugrunde, ein Verfahren sowie eine Vorrichtung zum Aufbringen einer Klebstoffschicht auf flächige Bauelemente zu schaffen, welche für eine Vielzahl von elektronischen Bauelementen, insbesondere für Bare Dies und mit einer vorgehärteten Klebstoffschicht versehenen Flip Chips und/oder Ball Grid Arrays, geeignet sind. Der Erfindung liegt ferner die Aufgabe zugrunde, eine Bestückvorrichtung zu schaffen, mittels der das erfindungsgemäße Verfahren effizient durchführbar ist.

Die verfahrensbezogene Aufgabe wird gelöst durch ein Verfahren zum Aufbringen einer Klebstoffschicht auf flächige Bauelemente mit den Merkmalen des unabhängigen Anspruchs 1.

Der Erfindung liegt die Erkenntnis zugrunde, dass ein Festkleben eines Bauelements an einer Klebstoffschicht dadurch verhindert werden kann, dass ein Hebemechanismus vorgesehen ist, welcher das Bauelement bevorzugt von unten aus der Klebstoffschicht herausdrückt. Dabei wird die mit einer Klebstoffschicht benetzte Unterseite des Bauelements nur an wenigen Stellen von der Hebeeinrichtung berührt, so dass eine Klebstoffschicht mit einer weitgehend homogenen Schichtdicke gewährleistet ist. Eine schonende Behandlung der Bauelemente wird dann gewährleistet, wenn beim Herausdrücken des Bauelements aus der Klebstoffschicht die in Richtung des Trägerelements gerichtete Druckkraft der Haltevorrichtung reduziert wird.

Es wird darauf hingewiesen, dass unter dem Begriff Klebstoff im Prinzip jedes pastenartige Material verstanden wird, welches zwischen einem auf einem Bauelementeträger bestückten Bauelement und dem Bauelementeträger eine gewisses Klebekraft vermittelt, die dafür sorgt, dass das Bauelement auch bei einer manchmal ruckartigen Handhabung des bestückten Bauelementeträgers exakt in seiner Bestückposition verbleibt. Gemäß der Erfindung kann die Klebstoffschicht deshalb beispielsweise Lotpaste, Flussmittel, elektrisch leitfähigen Klebstoff, elektrisch isolierenden Klebstoff, thermisch leitfähigen Klebstoff und/oder thermisch isolierenden Klebstoff aufweisen.

Die Erfindung eignet sich für beliebige flächige Bauelemente und insbesondere für sog. Wafer Level Underfilled Packages und Bare Dies, welche jeweils eine weitgehend plane Unterseite aufweisen, mit der die Bauelemente bei der Bestückung auf einen Bauelementeträger auf diesen aufgesetzt werden. Es wird darauf hingewiesen, dass auch die sog. Underfill-Klebstoffschicht mit dem erfindungsgemäßen Verfahren auf dafür vorgesehenen Bauelemente auf einfache Weise aufgetragen werden kann.

Das Verfahren nach Anspruch 2 hat den Vorteil, dass beim Herausdrücken des Bauelements eine Verkippung des Bauelements verhindert werden kann. Insbesondere bei großen Bauelementen ist es vorteilhaft, wenn das Bauelement durch eine Hebeeinrichtung aus der Klebstoffschicht herausgedrückt wird, welche Hebeeinrichtung an mehr als zwei, beispielsweise vier Teilbereichen der Unterseite des Bauelements angreift. Bei einer geeigneten Verteilung der Teilbereiche auf der flächigen Unterseite des Bauelements kann somit eine Verkippung des Bauelements mit hoher Sicherheit ausgeschlossen werden.

Das Verfahren nach Anspruch 3 hat den Vorteil, dass bei einer homogenen Schichtdicke des an dem Trägerelement befindlichen Klebstoffs auch die Schichtdicke des auf das Bauelement übertragenen Klebstoffs homogen ist.

Gemäß Anspruch 4 befindet sich die Klebstoffschicht auf einem stationären Trägerelement. Das Bauelement wird insbesondere durch ein Anheben der Hebeeinrichtung aus der Klebstoffschicht herausgedrückt. Dabei wird bevorzugt eine das Bauelement haltende Halteeinrichtung, welche an einem Bestückkopf federnd gelagert ist, durch das Anheben der Hebeeinrichtung relativ zu dem Bestückkopf eingefedert. Ebenso kann auch die Halteeinrichtung gemeinsam mit der Hebeeinrichtung nach oben bewegt werden, so dass keine oder eine nur sehr kleine Relativbewegung zwischen der Halteeinrichtung und der Hebeeinrichtung vorhanden ist. Vor dem in Kontakt Bringen eines er neuten Bauelements mit der Klebstoffschicht wird die Hebeeinrichtung relativ zu dem Trägerelement derart positioniert, dass an der Oberseite des Trägerelements eine ebene Fläche entsteht, an der sich die Klebstoffschicht befindet.

Nach Anspruch 5 wird das Bauelement bei ruhender Haltevorrichtung und ruhender Hebeeinrichtung durch ein Wegbewegen, insbesondere durch ein Absenken des Trägerelements von der Klebstoffschicht entfernt. Damit für ein nachfolgendes Bauelement wieder eine gleichmäßig dicke Klebstoffschicht an dem Trägerelement ausgebildet werden kann, wird nach dem Entfernen des Bauelements das Trägerelement wieder in eine Position gebracht, in der an der Oberseite des Trägerelements eine plane Fläche gewährleistet ist.

Das Verfahren nach Anspruch 6 wird insbesondere bei Bare Dies angewendet.

Das Verfahren nach Anspruch 7 wird insbesondere bei Flip Chips und/oder bei Ball Grid Arrays angewendet. Bei Wafer Level Underfilled Packages ist das Verfahren besonders vorteilhaft, da es eine effektive Möglichkeit darstellt, wie auf einfache Weise ein Festkleben an einem Klebstofffilm verhindert werden kann.

Die vorrichtungsbezogene Aufgabe der Erfindung wird gelöst durch eine Vorrichtung zum Aufbringen einer Klebstoffschicht auf flächige Bauelemente mit den Merkmalen des unabhängigen Anspruchs 8.

Die Verwendung einer Trägerplatte gemäß Anspruch 9 ermöglicht auf einfache Weise ein Bereitstellen des Klebstoffs in Form einer ebenen Klebstoffschicht.

Dabei wird darauf hingewiesen, dass die Fläche der Trägerplatte auch wesentlich größer als die Fläche eines Bauelements sein kann, so dass die Bauelemente an verschiedenen Stellen auf die Trägerplatte aufgesetzt werden können. Dies hat den Vorteil, dass durch ein einmaliges Bereitstellen einer großflächigen Klebstoffschicht auf eine Vielzahl von Bauelementen Klebstoff aufgebracht werden kann.

In diesem Zusammenhang wird ferner darauf hingewiesen, dass die Klebstoffschicht auch auf mehreren nebeneinander angeordnete Trägerplatten ausgebildet sein kann. In diesem Fall ist es ratsam, dass jeder Trägerplatte genau ein Hubelement zugeordnet ist, so dass effektiv ein Mehrzahl von Einzelvorrichtung entsteht, deren Handhabung im Vergleich zu einer einzelnen größeren Vorrichtung einfacher ist. Bei einer kleinen Einzelvorrichtung kann das Hubelement relativ zu der Trägerplatte mittels einer einfachen Linearlagerung präzise geführt werden, so dass die Gefahr eines unerwünschten Verkippens des Hubelements gegenüber der Trägerplatte reduziert wird. Damit wird auch das Risiko für eine mechanische Beschädigung durch eine versehentliche Verklemmung von Ejektor-Stiften innerhalb der Trägerplatte entsprechend klein.

Die Vorrichtung gemäß Anspruch 10 ermöglicht das Bereitstellen von Klebstoff innerhalb einer Klebstoffschicht mit gleichmäßiger Schichtdicke.

Die Verwendung von einem oder von mehreren sog. Ejektor-Stiften gemäß Anspruch 11 hat den Vorteil, dass das Bauelement lediglich an einer insgesamt kleinen Angriffsfläche von der Hebeeinrichtung berührt wird. Dabei sollten die Front-Flächen der Ejektor-Stifte jedoch so groß sein, dass eine Beschädigung des Bauelements durch übermäßig große lokale Druckeinwirkungen ausgeschlossen ist. Je nach Größe der Bauelemente werden ein oder mehrere Ejektor-Stifte verwendet. Bei sehr kleinen Bauelementen, welche eine Kantenlänge in der Größenordnung von 1 mm haben, wird nur ein einziger zentraler Stift verwendet, um das Bauelement aus der Klebstoffschicht herauszudrücken.

Die rasterförmige Anordnung von einer Mehrzahl von Ejektor-Stiften gemäß Anspruch 12 hat den Vorteil, dass beim Herausdrücken des Bauelements aus der Klebstoffschicht eine versehentliche Verkippung des Bauelements verhindert wird.

Die zweite vorrichtungsbezogene Aufgabe der Erfindung wird gelöst durch eine Bestückvorrichtung zum Bestücken von flächigen Bauelementen auf einem Bauelementeträger mit den Merkmalen des unabhängigen Anspruchs 13.

Die Ausführungsform nach Anspruch 14 hat den Vorteil, dass das Aufbringen einer Klebstoffschichten auf ein Bauelement während eines Verfahrens des Bestückkopfes erfolgen kann. Damit wird bei der automatischen Bestückung von Bauelementeträgern ein Zeitgewinn erzielt.

Gemäß Anspruch 15 erfolgt die Benetzung eines Bauelements mit einer Klebstoffschicht innerhalb einer sog. Bearbeitungsstation eines Revolverkopfes.

Es wird darauf hingewiesen, dass die Erfindung besonders vorteilhaft bei einem Aufeinanderbestücken von mehreren Bare Dies (sog. Chip-Stacking) eingesetzt werden kann. Dabei wird durch eine schichtweise Anordnung von mehreren Bare Dies zur Steigerung der Packungsdichte von Elektronik-Endprodukten auch die Richtung senkrecht zu der Oberfläche eines Bauelementeträgers ausgenutzt. Ein derartiges Ausnutzen der dritten Dimension kann auch mit anderen Bauelementen erfolgen, welche an zwei gegenüberliegenden flächigen Seiten elektrische Anschlüsse aufweisen.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1a, 1b und 1c: das Benetzen der flächigen Unterseite eines Bare Die-Bauelements mit einer Klebstoffschicht,
- Figur 2a, 2b und 2c: das Benetzen der flächigen Unterseite eines Wafer Level Underfilled-Bauelements mit einer Klebstoffschicht und
- Figur 3a und 3b: das Benetzen von Bare Die-Bauelementen mit einer Klebstoffschicht und das nachfolgende Bestücken der mit der Klebstoffschicht benetzten Bare Dies auf einem Bauelementeträger oder auf bereits bestückte Bare Dies.

An dieser Stelle bleibt anzumerken, dass sich in der Zeichnung die Bezugszeichen einander entsprechender Komponenten lediglich in ihrer ersten Ziffer unterscheiden.

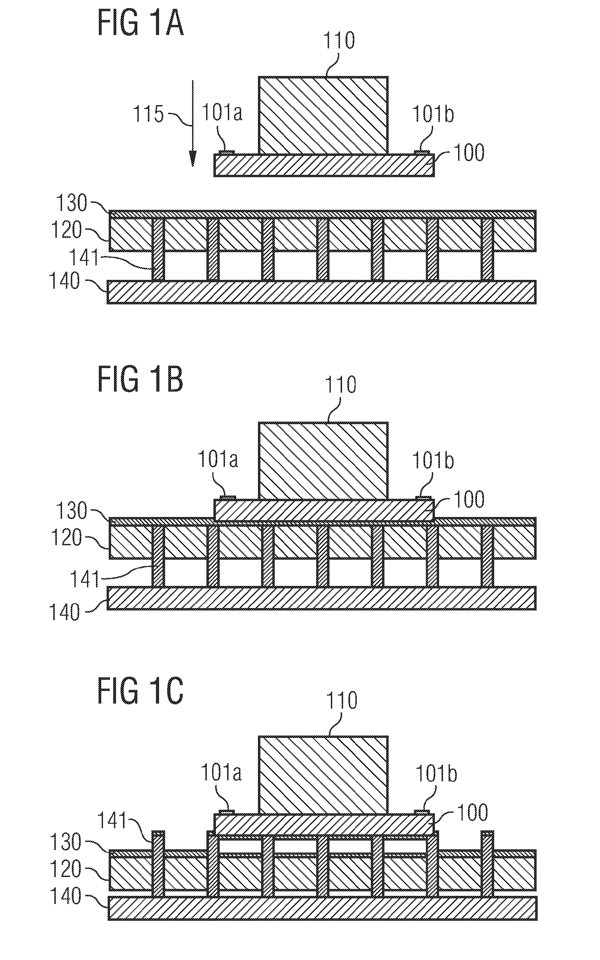

Figur 1a zeigt ein Bare Die-Bauelement 100, welches an seiner Oberseite zwei Anschlüsse 100a und 100b aufweist. Das Bauelement 100 wird von einer Haltevorrichtung 110 gehalten. Die Haltevorrichtung 110 ist beispielsweise eine sog. Saugpipette. Unterhalb des Bare Dies 100 befindet sich eine Trägerplatte 120, auf welcher sich Klebstoff 130 befindet, der in Form einer Klebstoffschicht auf der Trägerplatte 120 aufgetragen ist. Ferner ist ein Hebeelement 140 vorgesehen, an welchem Ejektor-Stifte 141 ausgebildet sind. Das Hebeelement 140 ist relativ zu der Trägerplatte 120 derart positioniert, dass die Front-Seiten der Ejektor-Stifte 141 in einer Ebene mit der flächigen Oberseite der Trägerplatte 120 liegen, wobei die Ejektor-Stifte 141 die Trägerplatte 120 durch entsprechend ausgebildete Bohrungen in der Trägerplatte 120 durchdringen. Die Ejektor-Stifte 141 sind über die Fläche der Trägerplatte 120 in einer regelmäßigen Anordnung verteilt. Mittels einer nicht dargestellten Nivelliereinrichtung wurde der auf der Trägerplatte 120 befindliche Klebstoff nivelliert. so dass der Klebstoff in Form einer Klebstoffschicht 130 mit gleichmäßiger Schichtdicke vorliegt.

Zum Benetzen der Unterseite des Bauelements 100 mit Klebstoff wird die Haltevorrichtung 110 entlang der Verschieberichtung 115 derart nach unten bewegt, dass das Bauelement 100 mit einer definierten Kraft in die Klebstoffschicht 130 gedrückt wird. Dies ist in Figur 1b dargestellt. Danach wird die Kraft, mit welcher das Bare Die-Bauelement 100 auf dem Klebstoffilm 130 gedrückt wird, reduziert und die Haltevorrichtung 110 gemeinsam mit dem Hebeelement 140 nach oben bewegt. Somit wird das Bauelement 100, welches sich an der Haltevorrichtung 110 befindet, bei einem Anheben der Haltevorrichtung 110 durch die gleichmäßige Bewegung der Haltevorrichtung 110 und des Hebeelements 140 von den Ejektor-Stiften 141 aus der Klebstoffschicht 130 herausgedrückt.

Wie aus Figur 1c ersichtlich, steht nachfolgend das Bauelement 100 nur mit den Front-Enden von einigen Ejektor-Stiften 141 in Kontakt. Damit ist die Klebewirkung zwischen den Ejektorstiften 141 und dem Bauelement 100 nicht so stark, dass bei einem weiteren alleinigen Anheben der Haltevorrichtung 110 das Bauelement 100 infolge der begrenzten Haltekraft der Haltevorrichtung 110 von dieser abgelöst wird. Das mit einer Klebstoffschicht benetzte Bauelement 100 kann somit von einem nicht dargestellten Bestückkopf, an welchem die Haltevorrichtung 110 angeordnet ist, zum Bestücken des Bauelements 100 an eine entsprechende Bestückposition auf einem Bauelementeträger transportiert werden.

Nach dem Entfernen des Bauelements 100 von den Ejektor-Stiften 140 wird das Hebeelement 140 abgesenkt (nicht dargestellt), so dass die Spitzen der Ejektor-Stifte 140 mit der Oberfläche der Trägerplatte 120 eine glatte Fläche darstellen. Danach wird bei Bedarf durch eine nicht dargestellte Dispensiervorrichtung neuer Klebstoff auf die Trägerplatte 120 aufgetragen und der auf der Trägerplatte 120 befindliche Klebstoff durch eine ebenfalls nicht dargestellte Nivelliereinrichtung geglättet, so dass erneut eine Klebstoffschicht mit gleichmäßiger Dichte vorliegt. Die Vorrichtung zum Auf bringen einer Klebstoffschicht auf flächige Bauelemente ist dann wieder in einem Zustand, in dem ein erneutes Bauelement an seiner Unterseite mit Klebstoff benetzt werden kann.

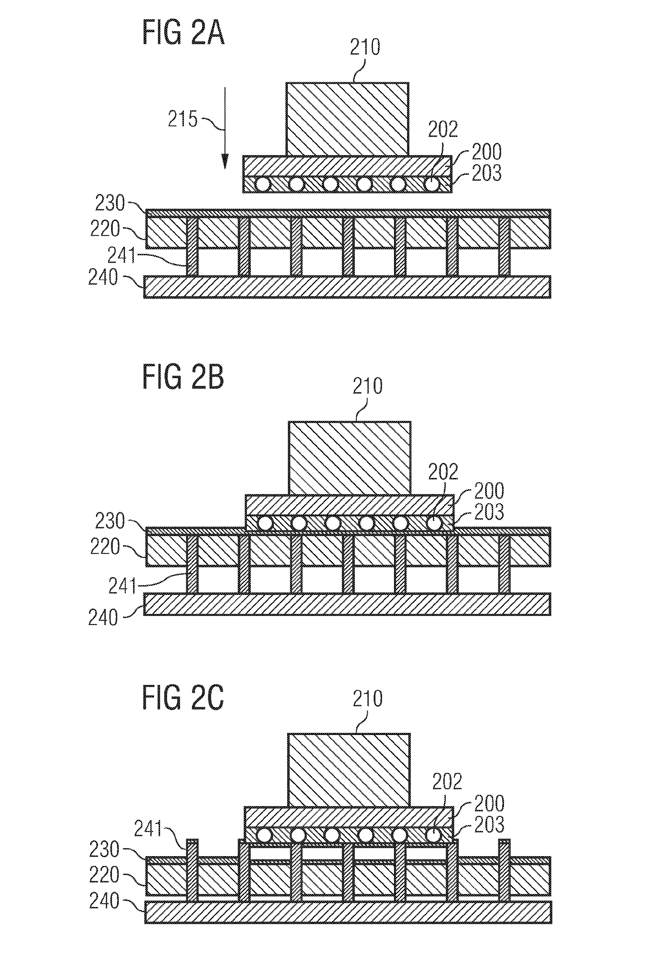

Die Figuren 2a, 2b und 2c zeigen das Benetzen der flächigen Unterseite eines sog. Wafer Level Underfilled-Bauelements 200 mit Klebstoff. An der Unterseite des Bauelements 200 befinden sich elektrische Anschlüsse 202 und eine vorgehärtete Underfill-Klebstoffschicht 203. Der Vorgang des Absenkens des Bauelements 200 auf eine Klebstoffschicht 230 und das nachfolgende Anheben des Bauelements 200 durch ein gleichmäßiges Bewegen einer Haltevorrichtung 210 und eines Hebeelements 240, an welchem Ejektor-Stifte 241 ausgebildet sind, ist mit dem in den Figuren 1a, 1b und 1c dargestellten Vorgang identisch. Aus diesem Grund wird im folgenden auf eine detaillierte Beschreibung der Figuren 2a, 2b und 2c verzichtet und auf die entsprechenden Abschnitte in der Beschreibung der Figuren 1a, 1b und 1c verwiesen.

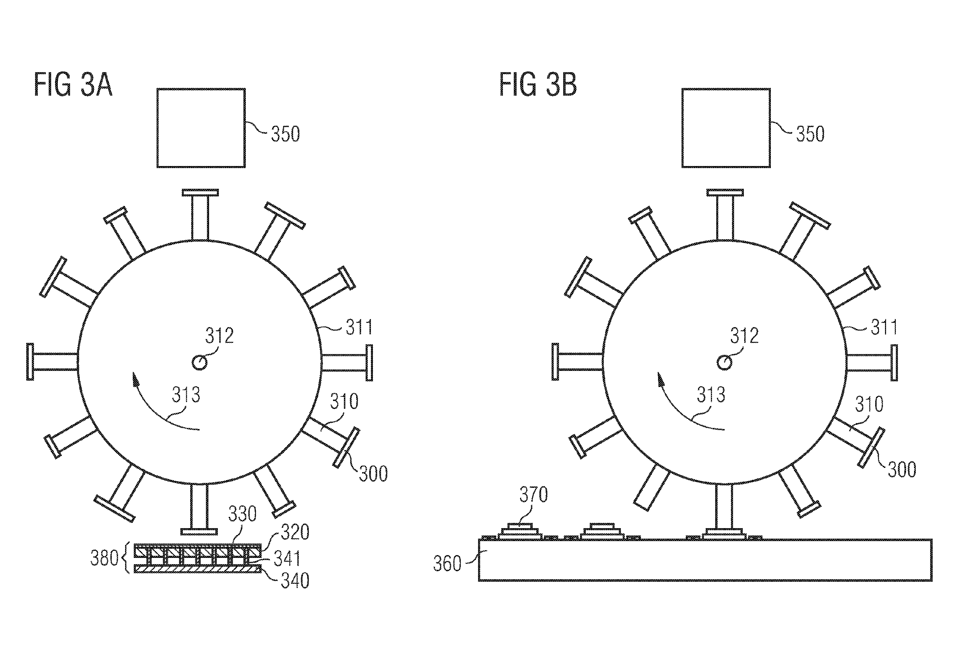

Die Figuren 3a und 3b zeigen das Benetzen von Bare Die-Bauelementen 300 mit Klebstoff und das nachfolgende Bestücken der Bauelemente 300 auf einem Bauelementeträger 360. Die Bestückung erfolgt mittels eines sog. Revolverkopfes 311, welcher eine Mehrzahl von sternförmig angeordneten Haltevorrichtungen 310 aufweist, die um eine Drehachse 312 herum entlang einer Drehrichtung 313 drehbar sind. Relativ zu der Drehachse 312 ist eine Kamera 350 derart angeordnet, dass Bauelemente 300, welche sich im Gesichtsfeld der Kamera 350 befinden, optisch erfasst werden können. Dabei können beispielsweise defekte Bauelemente 300 erkannt und aus dem Bestückprozess entfernt werden. Ferner dient die Kamera 350 dazu, die Lage der jeweils erfassten Bauelemente 300 zu erfassen. Somit kann beispielsweise durch eine Drehung der entsprechenden Haltevorrichtung 310 die Winkellage des Bauelements 300 variiert werden.

Der Revolverkopf 311 wird mittels einer nicht dargestellten Positioniervorrichtung derart positioniert, dass bei einer entsprechend getakteten Drehbewegung des Revolverkopfes 311 um die Drehachse 312 sämtliche von den Haltevorrichtungen 310 gehaltenen Bauelemente 300 sequentiell in den Behandlungsbereich einer Vorrichtung 380 transportiert werden, mittels der eine Klebstoffschicht auf die Unterseite der Bauelemente 300 aufgebracht wird. Die Vorrichtung 380 umfasst eine Trägerplatte 320, an welcher sich eine Klebstoffschicht 330 befindet. Die Vorrichtung 380 umfasst ferner ein Hebeelement 340, an welchem sich eine Mehrzahl von Ejektor-Stiften 341 befinden, welche die Trägerplatte 320 durch entsprechende Bohrungen durchdringen. Das Benetzen der Bauelemente 300 mit Klebstoff erfolgt genauso, wie es bereits oben anhand der Figuren 1a, 1b und 1c beschrieben wurde und wird an dieser Stelle nicht noch einmal erläutert.

Nach dem sequentiellen Benetzen von einer Mehrzahl von Bauelementen 300 mit Klebstoff wird der Revolverkopf 311 derart verfahren, dass bei einer getakteten Drehung des Revolverkopfes 311 und einer entsprechenden Aufwärts- und Abwärtsbewegung der Haltevorrichtungen 310 die mit Klebstoff benetzten Bauelemente 300 auf dem Bauelementeträger 360 aufgesetzt werden. Dabei können die Bauelemente 300 auch übereinander in Form eines Stapels 370 von Bare Dies 300 bestückt werden.

Es wird darauf hingewiesen, dass die Benetzung der Bauelemente 300 nicht unbedingt bei einer Winkelstellung des Revolverkopfes 311 erfolgen muss, in der die entsprechende Haltevorrichtung senkrecht nach unten gerichtet ist. So kann beispielsweise die Vorrichtung 380 zum Aufbringen einer Klebstoffschicht derart angeordnet sein, dass diejenigen Bauelemente, welche gerade von einer horizontal ausgerichteten Haltevorrichtung 310 gehalten werden, mit Klebstoff benetzt werden. Dabei ist zu beachten, dass ein Klebstoff mit einer bestimmten Viskosität verwendet wird. Nur dann kann verhindert werden, dass die Klebstoffschicht 330 infolge des Einflusses der Schwerkraft seitlich verläuft und damit ungleichmäßig dick wird.
Das Anordnen der Vorrichtung 380 zum Aufbringen einer Klebstoffschicht auf flächige Bauelemente in einer Position, die unterschiedlich zu der in Figur 3a dargestellten Position ist, hat den Vorteil, dass die Vorrichtung 380 ebenso wie die Kamera 350 in einer relativ zu der Drehachse 312 ortsfesten Position angeordnet sein kann. In diesem Fall stellt die Vorrichtung 380 zum Aufbringen einer Klebstoffschicht ebenso wie die Kamera 350 eine sog. Bearbeitungsstation dar, durch welche die Bauelemente 300 bei einer entsprechenden Drehung des Revolverkopfes 311 durchgetaktet werden. Dabei kann die Vorrichtung 380 derart angeordnet sein, dass ein zu bestückendes Bauelement 300 kurz vor dem Aufsetzen auf den Bauelementeträger 330 mit Klebstoff benetzt wird. Dies hat den Vorteil, dass die Zeitspanne zwischen dem Aufbringen der Klebstoffschicht auf das Bauelement 300 und dem Aufsetzen des Bauelements 300 auf den Bauelementeträger 360 oder auf ein bereits bestücktes Bauelement reduziert wird.

Zusammenfassend schafft die Erfindung ein Verfahren und eine Vorrichtung zum Aufbringen einer Klebstoffschicht auf flächige Bauelemente 100, insbesondere auf Bare Dies, Flip Chips und/oder Ball Grid Arrays, bei dem eine Unterseite eines von einer Haltevorrichtung 110 gehaltenen Bauelements 100 in eine Klebstoffschicht 130 eingetaucht wird. Durch die Verwendung einer Hebeeinrichtung wird sichergestellt, dass das Bauelement 100 bei einem Anheben der Haltevorrichtung 110 nicht von dieser gelöst wird, weil die Klebekraft des Klebstoffs 130 größer als die Haltekraft der Haltevorrichtung 110 ist. Dabei wird das Bauelement 100 aus der Klebstoffschicht 130 herausgedrückt, wobei die Hebeeinrichtung lediglich partiell an der Unterseite des Bauelements 100 angreift. Die Erfindung schafft ferner eine Bestückvorrichtung zum schnellen Bestücken von flächigen Bauelementen 300, bei der die Bauelemente 300 zunächst von einer Vorrichtung 380 zum Aufbringen einer Klebstoffschicht mit Klebstoff 330 benetzt und nachfolgend auf einem Bauelementeträger 360 oder auf ein bereits bestücktes Bauelement aufgesetzt werden.

## Patentansprüche

1. Verfahren zum Aufbringen einer Klebstoffschicht auf flächige Bauelemente, insbesondere auf Bare Dies, Flip Chips und/oder Ball Grid Arrays, bei dem
• eine Unterseite eines von einer Haltevorrichtung (110, 210) gehaltenen Bauelements (100, 200) mit Klebstoff (130, 230) in Kontakt gebracht wird, welcher sich an einem Trägerelement (120, 220) befindet, und
• das Bauelement (100, 200) von dem Trägerelement (120, 220) entfernt wird, wobei eine Hebeeinrichtung eingesetzt wird, welche an zumindest einem Teilbereich der Unterseite des Bauelements (100, 200) angreift und das Bauelement (100, 200) aus dem Klebstoff (130, 230) herausdrückt.

2. Verfahren nach Anspruch 1, bei dem
die Hebeeinrichtung (140, 141, 240, 241) an zumindest zwei Teilbereichen der Unterseite des Bauelements (100, 200) angreift.

3. Verfahren nach einem der Ansprüche 1 bis 2, bei dem
vor dem in Kontakt Bringen der Unterseite mit dem Klebstoff (130, 230) die dem Bauelement (100, 200) zugewandte Oberfläche des Klebstoffs (130, 230) nivelliert wird.

4. Verfahren nach einem der Ansprüche 1 bis 3, bei dem
das Bauelement (100, 200) durch ein Bewegen, insbesondere durch ein Anheben der Hebeeinrichtung relativ zu dem Trägerelement (120, 220) von dem Trägerelement (120, 220) entfernt wird.

5. Verfahren nach einem der Ansprüche 1 bis 4, bei dem
das Bauelement (100, 200) durch ein Wegbewegen, insbesondere durch ein Absenken des Trägerelements (120, 220) von dem Trägerelement (120, 220) entfernt wird.

6. Verfahren nach einem der Ansprüche 1 oder 5, bei dem
die Klebstoffschicht auf die den elektrischen Anschlüssen (101a, 101b) abgewandte Seite des Bauelements (100) aufgebracht wird.

7. Verfahren nach einem der Ansprüche 1 oder 5, bei dem
die Klebstoffschicht auf die mit elektrischen Anschlüssen (202) versehene Seite des Bauelements (200) aufgebracht wird.

8. Vorrichtung zum Aufbringen einer Klebstoffschicht auf flächige Bauelemente, insbesondere auf Bare Dies, Flip Chips und/oder Ball Grid Arrays, mit
• einer Haltevorrichtung (110, 210) zum temporären Halten eines Bauelements (100, 200),
• einem Trägerelement (120, 220), an welchem sich Klebstoff (130, 230) befindet,
• einer Hubeinrichtung, mittels welcher die Haltevorrichtung (110, 210) und das Trägerelement derart relativ zueinander bewegbar sind, dass die Unterseite eines an der Haltevorrichtung (110, 210) gehaltenen Bauelements (100, 200) mit Klebstoff (130, 230) in Kontakt bringbar ist, und
• einer Hebeeinrichtung (140, 141, 240, 241), derart ausgebildet, dass das Bauelement (100, 200) durch das Ausüben von Druck auf die Unterseite des Bauelements (100, 200) aus dem Klebstoff (130, 230) herausdrückbar ist.

9. Vorrichtung nach Anspruch 8, bei der das Trägerelement (120, 220) eine Trägerplatte ist.

10. Vorrichtung nach einem der Ansprüche 8 bis 9, zusätzlich mit
einer Nivelliereinrichtung, mittels welcher die Oberfläche des an dem Trägerelement (120, 220) befindlichen Klebstoffs (130, 230) nivellierbar ist.

11. Vorrichtung nach einem der Ansprüche 8 bis 10, bei der
die Hebeeinrichtung (140, 141, 240, 241) ein relativ zum Trägerelement (120, 220) verschiebbares Hebeelement (140, 240) aufweist, an welchem zumindest ein Ejektor-Stift (141, 241) vorgesehen ist, welcher bei entsprechender Relativbewegung zwischen Hebeelement (140, 240) und Trägerelement (120, 220) sowohl das Trägerelement (120, 220) als auch den Klebstoff (130, 230) durchdringt und das Bauelement (100, 200) aus dem Klebstoff (130, 230) herausdrückt.

12. Vorrichtung nach Anspruch 11, bei der
an dem Hebeelement (140, 240) eine Mehrzahl von Ejektor-Stiften (141, 241) vorgesehen sind, die relativ zueinander in Form eines Rasters angeordnet sind.

13. Bestückvorrichtung zum Bestücken von flächigen Bauelementen, insbesondere Bare Dies, Flip Chips und/oder Ball Grid Arrays, auf einem Bauelementeträger, mit
• einem Bestückkopf (311), mit welchem Bauelemente (300) von einer Entnahmeposition einer Bauelement-Zuführeinrichtung hin zu einer Aufsetzposition auf dem Bauelementeträger (360) transportierbar sind, und
• einer Vorrichtung nach einem der Ansprüche 8 bis 12.

14. Bestückvorrichtung nach Anspruch 13, bei welcher
die Vorrichtung relativ zu dem Bestückkopf (311) in einer festen räumlichen Position angeordnet oder relativ zu dieser festen räumlichen Position herum positionierbar ist.

15. Bestückvorrichtung nach einem der Ansprüche 13 bis 14, bei welcher
der Bestückkopf eine Mehrzahl von Haltevorrichtungen (310) aufweist, die sternförmig angeordnet und um eine Achse (312) herum drehbar sind.
